# EUROPEAN PATENT SPECIFICATION

(11) **EP 2 293 658 B1**
(45) Date of publication and mention of the grant of the patent: **14.11.2018**
(21) Application number: 10009326.9
(22) Date of filing: 08.09.2010
(51) Int. Cl.: H05K 7/20, G06F 1/18, G06F 1/20

(54) **Heat dissipating device**
Wärmeableitungsvorrichtung
Dispositif de dissipation de chaleur

(30) Priority: 08.09.2009 TW 98130218
(43) Date of publication of application: 09.03.2011
(73) Proprietor: Sunonwealth Electric Machine Industry Co., Ltd., Kaohsiung, Taiwan R.O.C. (TW)
(72) Inventor: Horng, Alex, Kaohsiung Taiwan R.O.C (TW); Yin, Tso-Kuo, Kaohsiung Taiwan R.O.C (TW)
(74) Representative: Louis Pöhlau Lohrentz

(56) References cited:
- EP-A2- 0 900 621
- WO-A1-2004/105261
- DE-U1- 20 309 986
- JP-A- 2008 165 699
- US-A1- 2005 219 814

## Description

### BACKGROUND OF THE INVENTION

### 1. Field of the Invention

The present invention generally relates to a heat dissipating device and, more particularly, to a heat dissipating device that can operate without adverse effect by moisture, dust, etc.

### 2. Description of the Related Art

Electronic elements, such as microprocessors, chips, etc., of most electronic products are generally concentrated and mounted in a casing. However, the temperature in a generally sealed inner chamber of the casing rises more rapidly as the functions of the electronic elements are upgraded and the operating speed of the electronic elements increases. Heat dissipating devices, such as fans or heat sinks, are provided to dissipate heat to maintain normal operation of the electronic elements at an appropriate temperature and to prolong the service lives of the electronic elements.

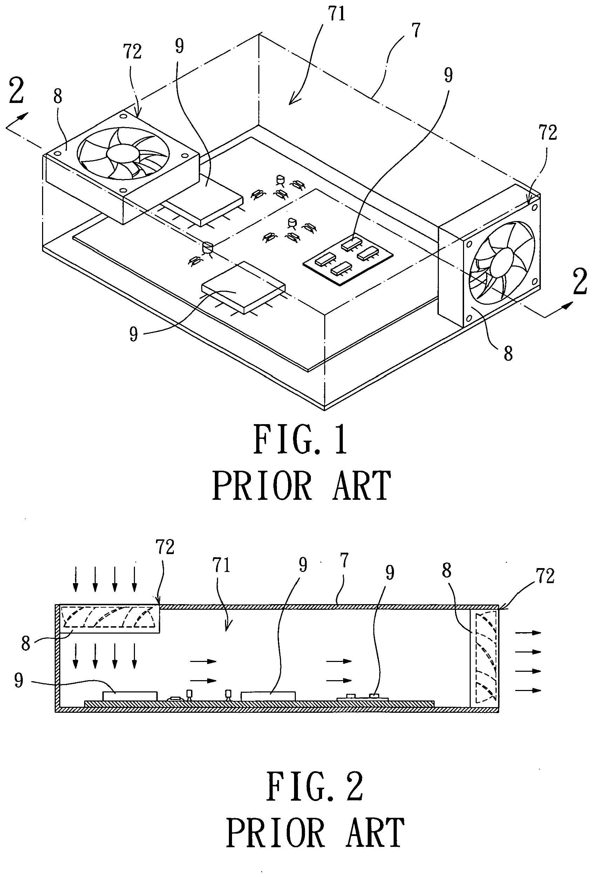

FIGS. 1 and 2 show a conventional heat dissipating device including a casing 7 and two fan units 8. Specifically, the casing 7 includes a compartment 71 for receiving a plurality of electronic elements 9. The casing 7 further includes two openings 72 in a top side and one of four sides of the casing 7, respectively. Each fan unit 8 is mounted on one of the openings 72. The electronic elements 9 generate heat during operation, causing a rise in temperature in the compartment 71. One of the fan units 8 draws ambient air at room temperature into the compartment 71 for heat exchange with the electronic elements 9. After heat exchange, the other fan unit 8 expels the hot air out of the compartment 71, dissipating heat out of the compartment 71 and enhancing the overall heat dissipating effect in the casing 7. However, moisture, dust, etc. contained in the ambient air enter the compartment 71 together with the air, moistening the electronic elements 9 and causing short circuit or even damage to the electronic elements 9. The service life of the electronic product using the electronic elements 9 is thus shortened.

Another conventional heat dissipating device is disclosed by the description of the related art of a PCT patent application publication numbered WO 2004/105261 A1 and entitled as "Housing Apparatus for Outdoor Communication Device." An outdoor communication device including a housing and a cooling device is proposed therein, and the cooling device has a heat sink installed inside the housing, with a blowing fan also installed in the housing to forcible exhaust air to an exterior through the heat sink. Furthermore, a porous plate having a plurality of pores and installed at the housing allowing air contained in the housing to be exhausted via the pores is used. Although the heat sink may transmit the heat produced by electronic communication appliances received in the housing for the air to dissipate the heat, the pores of the porous plate are not disposed in positions in alignment with the outlet of the blowing fan, and thus heated air may be kept in the housing easily and induce turbulence.

Still another conventional heat dissipating device is disclosed by a US patent application publication numbered US 2005/0219814 A1 and entitled as "Heat Dissipating Structure for an Electronic Device and Heat Dissipating Device." A heat dissipating member configuring a side wall of a case is proposed therein, wherein the heat dissipating member defines multiple through-holes having roughly the same shape and aligned approximately linear at roughly regular intervals. However, there is no fan unit arranged inside or adjacent to the heat dissipating member, and thus the air inside the heat dissipating member may not efficiently flow to dissipate the heat generated by a heat source in connection with the heat dissipating member.

Japanese patent application JP 2008 165 699, German utility model DE 203 09 986 U1 and European patent application EP 0 900 621 A2 A each discloses a heat dissipating device including a plurality of fins in the cooling channel extending from the heat conducting board towards but spaced from the opposing wall.

### SUMMARY OF THE INVENTION

An objective of the present invention is to provide a heat dissipating device that can operate without adverse effect by moisture, dust, etc, to prolong the service lives of electronic elements.

Another objective of the present invention is to provide a heat dissipating device that transfers the heat generated by the electronic elements to a chamber for heat dissipation purposes.

A further objective of the present invention is to provide a heat dissipating device that provides a heat conducting board to increase the heat exchange area of the electronic elements for enhancing the overall heat dissipating efficiency.

The present invention fulfills the above objectives by providing, in a preferred form, a heat dissipating device which includes a casing having a compartment. Two heat conducting boards are mounted in the compartment and divide the compartment into a first chamber and a second chamber with the two heat conducting boards located between the first and second chambers. The first chamber includes a first air channel and a second air channel in communication with the first air channel. The first chamber further includes first and second outlet openings. The first outlet opening is located on an end of the first air channel. The second outlet opening is located on an end of the second air channel. The at least one fan unit includes at least one air inlet and two air outlets. The two air outlets are respectively aligned and in communication with the first and second outlet openings via the first and second air channels.

By utilizing the heat conducting board to absorb the heat generated by the electronic elements in the second chamber and by creating airflow in the first chamber with the fan unit, the temperature of the second chamber and of the electronic elements is lowered. Furthermore, the electronic elements will not be moistened or contaminated by moisture, dust or the like, thereby prolonging the service life and enhancing the stability of an electronic product that uses these electronic elements.

The present invention will become clearer in light of the following detailed description of its illustrative embodiments described in connection with the drawings.

### BRIEF DESCRIPTION OF THE DRAWINGS

The illustrative embodiments may best be described by referring to the accompanying drawings where:
FIG. 1 shows a perspective view of a conventional heat dissipating device.
FIG. 2 shows a cross sectional view of the heat dissipating device of FIG. 1 according to section line 2-2 of FIG. 1.
FIG. 3 shows an exploded, perspective view of a heat dissipating device of a first embodiment according to the preferred teachings of the present invention.
FIG 4 shows a top view of the heat dissipating device of FIG. 3.
FIG. 5 shows a cross sectional view of the heat dissipating device of FIG. 3 according to section line 5-5 of FIG. 4.
FIG. 6 shows an exploded, perspective view of a heat dissipating device of a second embodiment according to the preferred teachings of the present invention.
FIG. 7 shows a top view of the heat dissipating device of FIG. 6.
FIG. 8 shows a cross sectional view of the heat dissipating device of FIG. 6 according to section line 8-8 of FIG. 7.
FIG. 9 shows an exploded, perspective view of a heat dissipating device of a third embodiment according to the preferred teachings of the present invention.
FIG. 10 shows a top view of the heat dissipating device of FIG 9.

All figures are drawn for ease of explanation of the basic teachings of the present invention only; the extensions of the figures with respect to number, position, relationship, and dimensions of the parts to form the preferred embodiments will be explained or will be within the skill of the art after the following teachings of the present invention have been read and understood. Further, the exact dimensions and dimensional proportions that conform to specific force, weight, strength, and similar requirements will likewise be within the skill of the art after the following teachings of the present invention have been read and understood.

Where used in the various figures of the drawings, the same numerals designate the same or similar parts. Furthermore, when the terms "first", "second", "third", "fourth", "lower", "upper", "side", "end", and similar terms are used herein, it should be understood that these terms refer only to the structure shown in the drawings as it would appear to a person viewing the drawings and are utilized only to facilitate describing the invention.

### DETAILED DESCRIPTION OF THE INVENTION

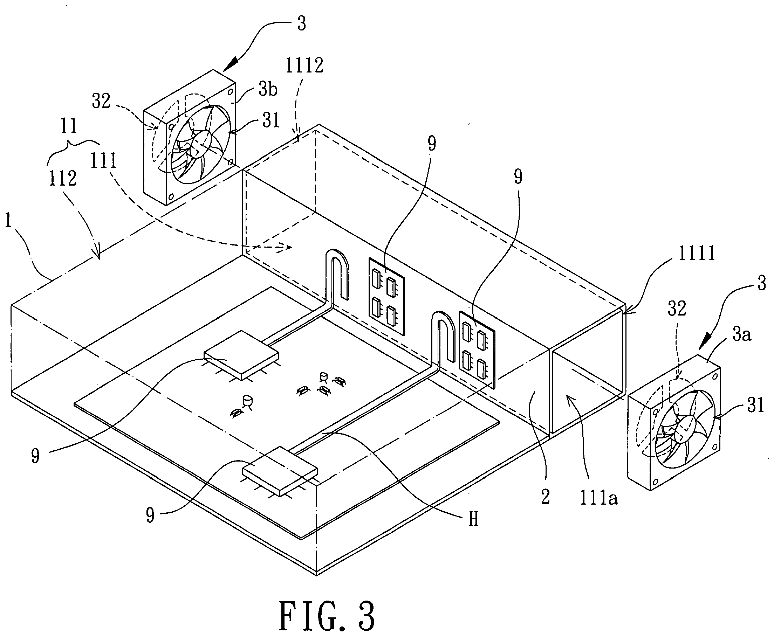

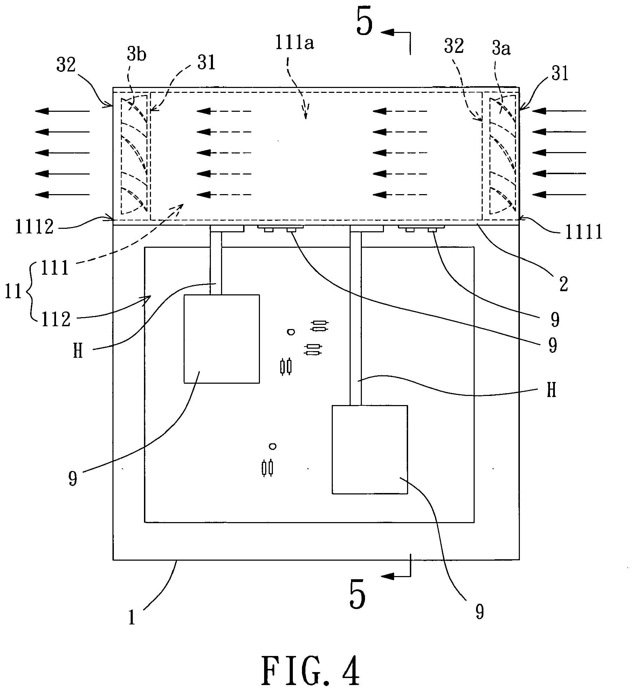

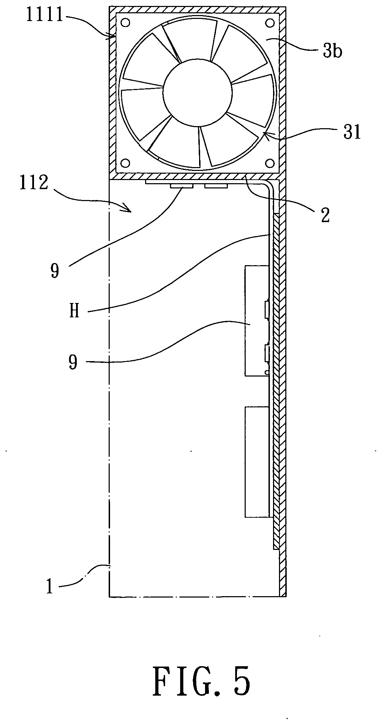

A heat dissipating device of a first embodiment according to the preferred teachings of the present invention is shown in FIGS. 3-5. The heat dissipating device is utilized to dissipate heat generated by a plurality of electronic elements 9 mounted in a casing of an electronic product such as a camera, electronic digital displayer, notebook, satellite navigation device, etc. The heat dissipating device includes a casing 1, at least one heat conducting board 2 and at least one fan unit 3. The casing 1 includes a compartment 11. The at least one heat conducting board 2 is integrally formed or detachably mounted in the compartment 11, dividing the compartment 11 into a first chamber that receives at least one fan unit 3 and a second chamber that receives the electronic elements 9 such as circuit boards, microprocessors, chips, etc. The at least one heat conducting board 2 is made of metal with excellent heat conduction characteristics, such as aluminum, copper, gold, silver, or an alloy thereof.

In the first embodiment, the heat dissipating device includes only one heat conducting board 2 which is located in the compartment 11 and separates it into a first chamber 111 and a second chamber 112. The first chamber 111 defines a first air channel 111a. Furthermore, the first chamber 111 includes a plurality of openings. In the first embodiment, the first chamber 111 includes a first outlet opening 1111 at one end of the first air channel 111a and a second outlet opening 1112 at the other end of the first air channel 111a.

The at least one fan unit 3 is mounted in the first chamber 111 and can be of an axial-flow type or blower type. In the first embodiment, the heat dissipating device includes first and second fan units 3a and 3b of the axial-flow type. The first and second fan units 3a and 3b are respectively mounted on the ends of the first air channel 111a. Each of the first and second fan units 3a and 3b includes an air inlet 31 and an air outlet 32. The air inlet 31 of the first fan unit 3a is aligned and in communication with the first outlet opening 1111. The air outlet 32 of the second fan unit 3b is aligned and in communication with the second outlet opening 1112.

With reference to FIGS. 3-5, in using the heat dissipating device of the first embodiment according to the teachings of the present invention, the electronic elements 9 of the electronic product is mounted in the second chamber 112 of the casing 1. Some of the electronic elements 9 can be in direct contact with a side of the heat conducting board 2. Other electronic elements 9 can be connected to the heat conducting board 2 by one or more heat pipes H or the like.

The electronic elements 9 generate heat during operation, leading to an increase in the temperature in the second chamber 112. The heat conducting board 2 absorbs the heat generated by the electronic elements 9 in direct contact with the side of the heat conducting board 2 and absorbs the heat generated by the other electronic elements 9 via the heat pipes H. Thus, the temperature of the heat conducting board 2 rises. At the same time, the first fan unit 3a draws in ambient air at room temperature via the first outlet opening 1111 and the air inlet 31 of the first fan unit 3a. The air at room temperature is then sent into the first air channel 111a via the air outlet 32 of the first fan unit 3a to proceed with heat exchange with the heat conducting board 2 and is turned into hot air, thereby lowering the temperature of the heat conducting board 2. The hot air after heat exchange is drawn into the air inlet 31 of the second fan unit 3b and then expelled from the air outlet 32 of the second fan unit 3b. Continuous airflow can be created in the first air channel 111a to dissipate heat from the heat conducting board 2.

According to the teachings of the present invention, by utilizing the side of the heat conducting board 2 to absorb the heat generated by the electronic elements 9 in the second chamber 112 and by creating airflow in the first chamber 111 at the other side of the heat conducting board 2 with the fan unit 3, the temperature of the second chamber 112 and the electronic elements 9 is lowered. Furthermore, since the first and second chambers 111 and 112 are independent from each other, the first chamber 111 can be in communication with or not with the second chamber 112. In the first embodiment, the first chamber 111 is not in communication with the second chamber 112. Thus, moisture, dust or the like contained in the ambient air and drawn together with the air by the fan unit 3 into the first chamber 111 will not enter the second chamber 112. Thus, the electronic elements 9 will not be moistened or contaminated by the moisture, dust or the like, thereby avoiding short circuit of the electronic elements 9 and prolonging the service life and enhancing the stability of the electronic product.

Furthermore, since the electronic elements 9 can be either directly bonded to or indirectly coupled by heat pipes H to the heat conducting board 2, the heat generated by the electronic elements 9 can be more directly and rapidly transferred to the heat conducting board 2 for heat dissipation purposes. The overall heat dissipating effect of the heat dissipating device of the teachings of the present invention is thus enhanced.

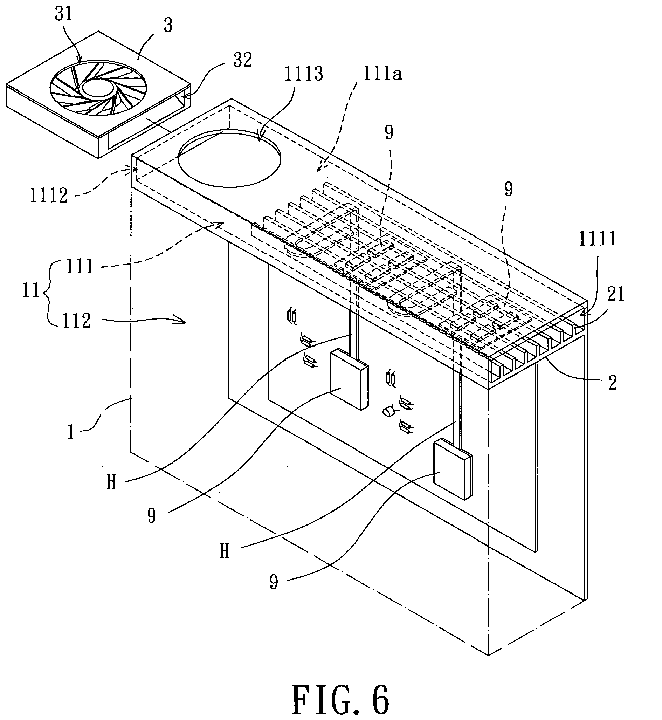

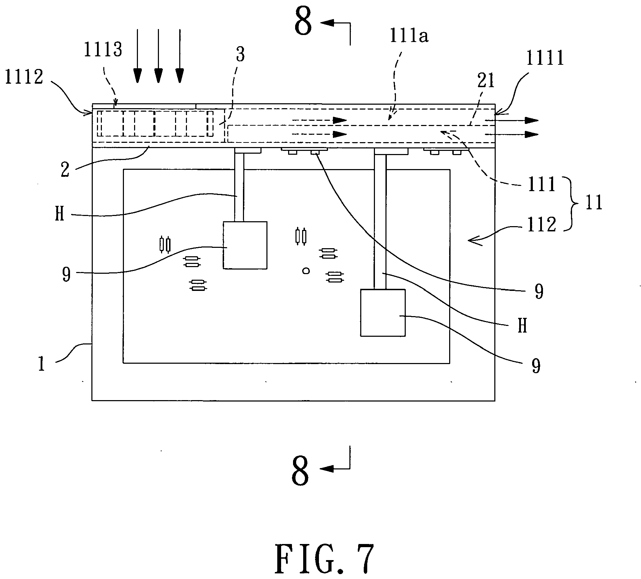

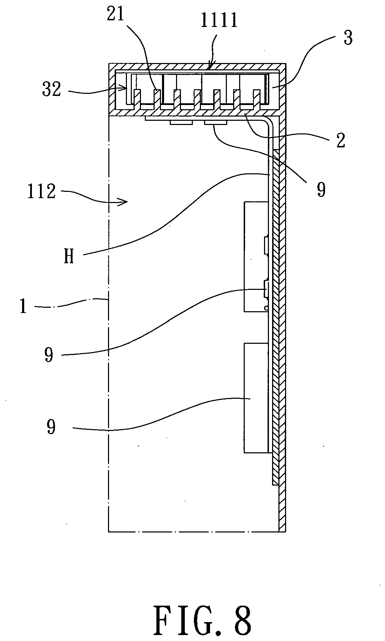

FIGS. 6-8 show a heat dissipating device of a second embodiment according to the preferred teachings of the present invention. Compared to the first embodiment, the first chamber 111 of the heat dissipating device of the second embodiment includes first and second outlet openings 1111 and 1112, and third opening 1113. The first outlet opening 1111 is at one end of the first air channel 111a, the second outlet opening 1112 is at the other end of the first air channel 111a, and the third opening 1113 is on a side (the top side in the preferred form shown) of the first chamber 111 and in communication with the first air channel 111a. Furthermore, the fan unit 3 is mounted to the first air channel 111a via the second outlet opening 1112.

With reference to FIGS. 6-8, a plurality of fins 21 is mounted to a side of the heat conducting board 2. The fins 21 are parallel to each other and located in the first air channel 111a. Furthermore, each fin 21 extends from the first outlet opening 1111 towards, but spaced from the second outlet opening 1112. The fan unit 3 is of the blower type and includes an air inlet 31 and an air outlet 32. The air inlet 31 is aligned and in communication with the third opening 1113. The air outlet 32 is aligned and in communication with the first outlet opening 1111.

In this embodiment, by utilizing the side of the heat conducting board 2 to absorb the heat generated by the electronic elements 9 in the second chamber 112 and by drawing air at room temperature into the first air channel 111a with the fan unit 3 to dissipate heat from the heat conducting board 2 and the fins 21, the temperature of the heat conducting board 2 is lowered, because the heat accumulated in the heat conducting board 2 and the fins 21 is carried away by the air. After heat exchange, the hot air is expelled from the first outlet opening 1111. Thus, the temperature of the second chamber 112 and the electronic elements 9 in the second chamber 112 can be effectively lowered while prolonging the service life and enhancing the stability of the electronic product by preventing moisture, dust or the like from entering the second chamber 112.

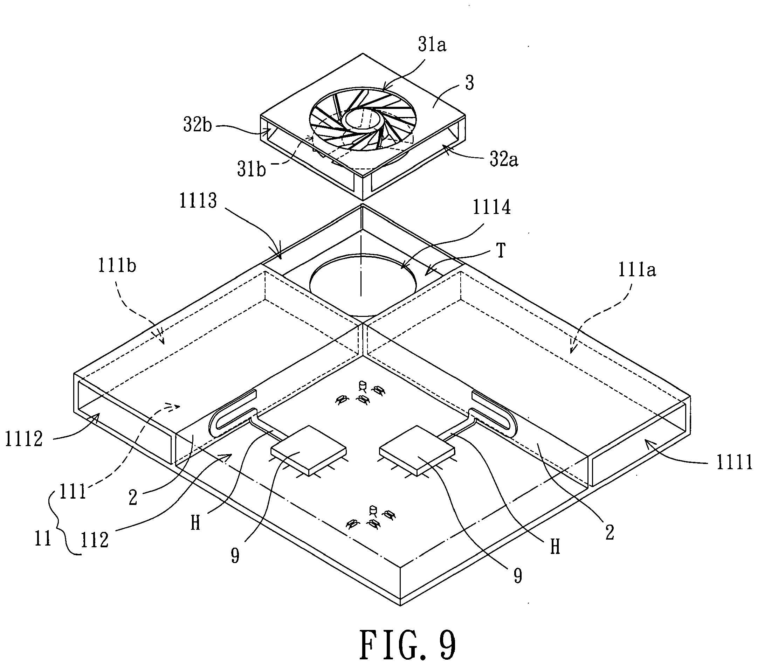

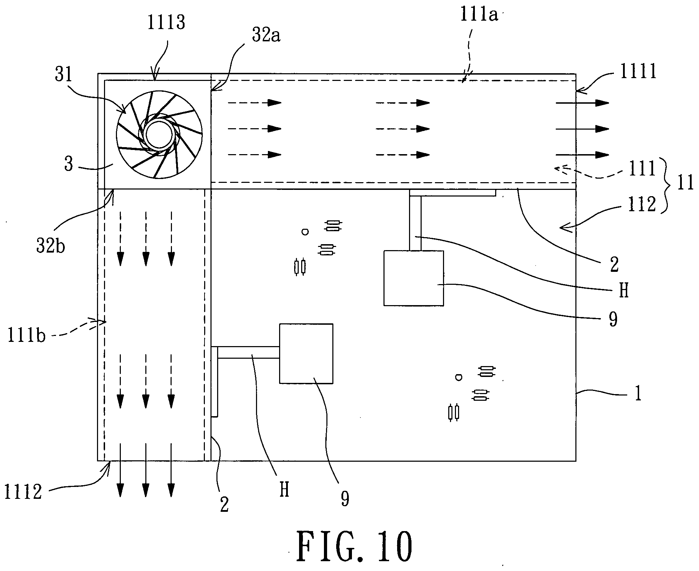

FIGS. 9 and 10 show a heat dissipating device of a third embodiment according to the preferred teachings of the present invention. Compared to the second embodiment, the heat dissipating device of the third embodiment includes two heat conducting boards 2 to separate the compartment 11 into a first chamber 111 and a second chamber 112. The first chamber 111 is substantially L-shaped in cross section and includes a first air channel 111a and a second air channel 111b in communication with the first air channel 111a. An intersection of the first and second air channels 111a and 111b forms a mounting area T in which the fan unit 3 is mounted. The first chamber 111 includes first and second outlet openings 1111 and 1112, and third and fourth openings 1113 and 1114. The first outlet opening 1111 is located on one end of the first air channel 111a, and the second outlet opening 1112 is located on one end of the second air channel 111b. The third opening 1113 is located on a top side of the mounting area T, and the fourth opening 1114 is located on a bottom side of the mounting area T. The fan unit 3 can be mounted to the mounting area T via the third opening 1113.

The fan unit 3 includes a first air inlet 31a, a second air inlet 31b, a first air outlet 32a, and a second air outlet 32b. When the fan unit 3 is mounted to the mounting area T, the first air inlet 31a is aligned and in communication with the third opening 1113, the second air inlet 31b is aligned and in communication with the fourth opening 1114, the first air outlet 32a is in communication with the first outlet opening 1111 via first air channel 111a, and the second air outlet 32b is in communication with the second outlet opening 1112 via the second air channel 111b.

In this embodiment, by utilizing the heat conducting boards 2 to absorb the heat generated by the electronic elements 9 in the second chamber 112 and by drawing air at room temperature into the first air channels 111a and 111b with the fan unit 3 via the first and second air inlets 31a and 31b to dissipate heat from the heat conducting boards 2, the temperature of the heat conducting boards 2 is lowered because the heat accumulated in the heat conducting boards 2 is carried away by the air. After heat exchange, the hot air is expelled from the first and second outlet openings 1111 and 1112. Thus, the temperature of the second chamber 112 and the electronic elements 9 in the second chamber 112 can be effectively lowered while prolonging the service life and enhancing the stability of the electronic product by preventing moisture, dust or the like from entering the second chamber 112.

Furthermore, the heat exchange area between the heat conducting boards
2 and the second chamber 112 as well as the electronic elements 9 is largely increased when the fan unit 3 drives air to flow through the first and second air channels 111a and 111b for dissipating heat from the heat conducting boards 2, enhancing the overall heat dissipating efficiency and maintaining a stable operating temperature for the electronic elements 9.

## Claims

1. A heat dissipating device comprising:
a casing (1) including a compartment (11);
two heat conducting boards (2) mounted in the compartment (11) and dividing the compartment (11) into a first chamber (111) and a second chamber (112) with the two heat conducting boards (2) located between the first and second chambers (111, 112);
and at least one fan unit (3) mounted in the first chamber (111),
wherein the heat dissipating device is **characterized in that** the first chamber (111) includes a first air channel (111a) and a second air channel (111b) in communication with the first air channel (111a), with the first chamber (111) further including first and second outlet openings (1111, 1112), with the first outlet opening (1111) located on an end of the first air channel (111a), with the second outlet opening (1112) located on an end of the second air channel (111b), with the at least one fan unit (3) including at least one air inlet (31) and two air outlets (32a, 32b), with said two air outlets (32a, 32b) respectively aligned and in communication with the first and second outlet openings (1111, 1112) via the first and second air channels (111a, 111b).

2. The heat dissipating device as claimed in claim 1,
**characterized in that**
a plurality of openings includes the first and the second outlet openings (1111, 1112).

3. The heat dissipating device as claimed in claim 1,
**characterized in that**
the first and second air channels (111a, 111b) have an intersection forming a mounting area (T), and with the at least one fan unit (3) mounted to the mounting area (T).

4. The heat dissipating device as claimed in claim 3,
**characterized in that**
a plurality of openings includes the first and the second outlet openings (1111, 1112) and that the plurality of openings further include third and fourth openings (1113, 1114), with the third opening (1113) located on a top side of the mounting area (T), and with the fourth opening (1114) located on a bottom side of the mounting area (T).

5. The heat dissipating device as claimed in claim 4,
**characterized in that**
the at least one fan unit (3) includes a first air inlet (31a) and a second air inlet (31b) of the at least one air inlet, and a first air outlet (32a) and a second air outlet (32b) of the two air outlets, with the first air inlet (31a) aligned and in communication with the third opening (1113), with the second air inlet (31b) aligned and in communication with the fourth opening (1114), with the first air outlet (32a) in communication with the first outlet opening (1111) via the first air channel (111a), and with the second air outlet (32b) in communication with the second outlet opening (1112) via the second air channel (111b).

6. The heat dissipating device as claimed in claim 1,
**characterized in that**
said two heat conducting boards (2) include a plurality of fins (21), with the plurality of fins (21) parallel to each other and located in the air channel (111a).

## Patentansprüche

1. Wärmeableitungsvorrichtung, die Folgendes umfasst:
ein Gehäuse (1), das ein Fach (11) aufweist;
zwei wärmeleitende Platten (2), die in dem Fach (11) montiert sind und das Fach (11) in eine erste Kammer (111) und eine zweite Kammer (112) unterteilen, wobei sich die zwei wärmeleitenden Platten (2) zwischen der ersten und der zweiten Kammer (111, 112) befinden;
und wenigstens eine Gebläseeinheit (3), die in der ersten Kammer (111) montiert ist,
wobei die Wärmeableitungsvorrichtung **dadurch gekennzeichnet ist, dass**
die erste Kammer (111) einen ersten Luftkanal (111a) und einen zweiten Luftkanal (111b) in Kommunikation mit dem ersten Luftkanal (111a) umfasst, wobei die erste Kammer (111) ferner eine erste und eine zweite Auslassöffnung (1111, 1112) umfasst, wobei sich die erste Auslassöffnung (1111) an einem Ende des ersten Luftkanals (111a) befindet, wobei sich die zweite Auslassöffnung (1112) an einem Ende des zweiten Luftkanals (111b) befindet, wobei die wenigstens eine Gebläseeinheit (3) wenigstens einen Lufteinlass (31) und zwei Luftauslässe (32a, 32b) umfasst, wobei die zwei Luftauslässe (32a, 32b) jeweils auf die erste und die zweite Auslassöffnung (1111, 1112) ausgerichtet sind und über den ersten und den zweiten Luftkanal (111a, 111b) damit in Kommunikation sind.

2. Wärmeableitungsvorrichtung nach Anspruch 1,
**dadurch gekennzeichnet, dass**
mehrere Öffnungen die erste und die zweite Auslassöffnung (1111, 1112) umfassen.

3. Wärmeableitungsvorrichtung nach Anspruch 1,
**dadurch gekennzeichnet, dass**
der erste und der zweite Luftkanal (111a, 111b) eine Kreuzung aufweisen, die einen Montagebereich (T) bildet, und wobei die wenigstens eine Gebläseeinheit (3) an dem Montagebereich (T) montiert ist.

4. Wärmeableitungsvorrichtung nach Anspruch 3,
**dadurch gekennzeichnet, dass**
mehrere Öffnungen die erste und die zweite Auslassöffnung (1111, 1112) umfassen und dass die mehreren Öffnungen ferner eine dritte und eine vierte Öffnung (1113, 1114) umfassen, wobei sich die dritte Öffnung (1113) an einer oberen Seite des Montagebereichs (T) befindet und wobei sich die vierte Öffnung (1114) an einer unteren Seite des Montagebereichs (T) befindet.

5. Wärmeableitungsvorrichtung nach Anspruch 4,
**dadurch gekennzeichnet, dass**
die wenigstens eine Gebläseeinheit (3) einen ersten Lufteinlass (31a) und einen zweiten Lufteinlass (31b) des wenigstens einen Lufteinlasses und einen ersten Luftauslass (32a) und einen zweiten Luftauslass (32b) der zwei Luftauslässe umfasst, wobei der erste Lufteinlass (31a) auf die dritte Öffnung (1113) ausgerichtet und mit dieser in Kommunikation ist, wobei der zweite Lufteinlass (31b) auf die vierte Öffnung (1114) ausgerichtet und mit dieser in Kommunikation ist, wobei der erste Luftauslass (32a) mit der ersten Auslassöffnung (1111) über den ersten Luftkanal (111a) in Kommunikation ist und wobei der zweite Luftauslass (32b) mit der zweiten Auslassöffnung (1112) über den zweiten Luftkanal (111b) in Kommunikation ist.

6. Wärmeableitungsvorrichtung nach Anspruch 1,
**dadurch gekennzeichnet, dass**
die zwei wärmeleitenden Platten (2) mehrere Lamellen (21) aufweisen, wobei die mehreren Lamellen (21) parallel zueinander sind und sich in dem Luftkanal (111a) befinden.

## Revendications

1. Dispositif de dissipation de chaleur comprenant :
un carter (1) comprenant un compartiment (11) ;
deux panneaux thermoconducteurs (2) montés dans le compartiment (11) et divisant le compartiment (11) entre une première chambre (111) et une seconde chambre (112) avec les deux panneaux thermoconducteurs (2) positionnés entre les première et seconde chambres (111, 112) ; et au moins une unité de ventilateur (3) montée dans la première chambre (111),
dans lequel le dispositif de dissipation de chaleur est **caractérisé en ce que** :
la première chambre (111) comprend un premier canal d'air (111a) et un second canal d'air (111b) en communication avec le premier canal d'air (111a), avec la première chambre (111) qui comprend en outre des première et deuxième ouvertures de sortie (1111, 1112), avec la première ouverture de sortie (1111) positionnée sur une extrémité du premier canal d'air (111a), avec la deuxième ouverture de sortie (1112) positionnée sur une extrémité du second canal d'air (111b), avec la au moins une unité de ventilateur (3) qui comprend au moins une entrée d'air (31) et deux sorties d'air (32a, 32b), avec lesdites deux sorties d'air (32a, 32b) respectivement alignées et en communication avec les première et deuxième ouvertures de sortie (1111, 1112) via des premier et second canaux d'air (111a, 111b).

2. Dispositif de dissipation de chaleur selon la revendication 1,
**caractérisé en ce que** :
une pluralité d'ouvertures comprend les première et deuxième ouvertures de sortie (1111, 1112).

3. Dispositif de dissipation de chaleur selon la revendication 1,
**caractérisé en ce que** :
les premier et second canaux d'air (111a, 111b) ont une intersection formant une zone de montage (T), et avec la au moins une unité de ventilateur (3) montée sur la zone de montage (T).

4. Dispositif de dissipation de chaleur selon la revendication 3,
**caractérisé en ce que** :
la pluralité d'ouvertures comprend les premières et les deuxièmes ouvertures de sortie (1111, 1112) et **en ce que** la pluralité d'ouvertures comprend en outre des troisième et quatrième ouvertures (1113, 1114), avec la troisième ouverture (1113) positionnée sur un côté supérieur de la zone de montage (T), et avec la quatrième ouverture (1114) positionnée sur un côté inférieur de la zone de montage (T).

5. Dispositif de dissipation de chaleur selon la revendication 4,
**caractérisé en ce que** :
la au moins une unité de ventilateur (3) comprend une première entrée d'air (31a) et une seconde entrée d'air (31b) de la au moins une entrée d'air, et une première sortie d'air (32a) et une seconde sortie d'air (32b) des deux sorties d'air, avec la première entrée d'air (31a) alignée et en communication avec la troisième ouverture (1113), avec la seconde entrée d'air (31b) alignée et en communication avec la quatrième ouverture (1114), avec la première sortie d'air (32a) en communication avec la première ouverture de sortie (1111) via le premier canal d'air (111a), et avec la seconde sortie d'air (32b) en communication avec la deuxième ouverture de sortie (1112) via le second canal d'air (111b).

6. Dispositif de dissipation de chaleur selon la revendication 1,
**caractérisé en ce que** :
lesdits deux panneaux thermoconducteurs (2) comprennent une pluralité d'ailettes (21), avec la pluralité d'ailettes (21) parallèles entre elles et positionnées dans le canal d'air (111a).
